(19) Europäisches Patentamt

European Patent Office

Office européen des brevets

(11) **EP 1 701 385 A1**

(12) **EUROPEAN PATENT APPLICATION**
published in accordance with Art. 158(3) EPC

(43) Date of publication:
**13.09.2006 Bulletin 2006/37**

(51) Int Cl.:
*H01L 27/04* (2006.01)   *H01L 23/60* (2006.01)

(21) Application number: **04819472.4**

(22) Date of filing: **29.11.2004**

(86) International application number:
**PCT/JP2004/017701**

(87) International publication number:
**WO 2005/053028 (09.06.2005 Gazette 2005/23)**

(84) Designated Contracting States:
**DE FR GB**

(30) Priority: **27.11.2003 JP 2003397099**

(71) Applicant: **MATSUSHITA ELECTRIC INDUSTRIAL CO., LTD.**
**Kadoma-shi, Osaka 571-8501 (JP)**

(72) Inventors:
• **KOJIMA, Iwao,**
**Matsushita Electric Ind. Co., Ltd.**
**Chuo-ku,Osaka-shi,**
**Osaka 540-6319 (JP)**

• **SHOGAKI, Toshihiro,**
**Matsushita Elec.Ind. Co., Ltd.**
**Chuo-ku,Osaka-shi,**
**Osaka 540-6319 (JP)**
• **ISHIKAWA, Osamu,**
**Matsushita Electric Ind.Co., Ltd.**
**Chuo-ku,Osaka-shi,**
**Osaka 540-6319 (JP)**

(74) Representative: **Eisenführ, Speiser & Partner**
**Patentanwälte Rechtsanwälte**
**Postfach 10 60 78**
**28060 Bremen (DE)**

(54) **SEMICONDUCTOR DEVICE COMPRISING ELECTROSTATIC BREAKDOWN PROTECTION ELEMENT**

(57)     A semiconductor device (1) comprises a semiconductor substrate (2) on which an integrated (3, 4) formed, a first ground terminal (7) and a second ground terminal (8) for electrically connecting the integrated (3, 4) to an external ground electrode, and an electrostatic breakdown protection element (5) for electrically connecting the first ground terminal (7) with the second ground terminal (8). The first ground terminal (7) is electrically connected with the semiconductor substrate (2), while the second ground terminal (8) is not electrically connected with the semiconductor substrate (2).

FIG. 1

EP 1 701 385 A1

**Description**

TECHNICAL FIELD

The present invention relates to a semiconductor device having an electrostatic breakdown protection element which requires a high electrostatic withstand voltage and a high-frequency characteristic.

BACKGROUND ART

In recent years, in the field of semiconductor devices, there has been considered not only a combination of an analog circuit and a digital circuit but also an integration of a power amplifier, a low noise amplifier, and the like, which have been constituted as a single element. With the development of high integration and high functionality of the semiconductor devices, techniques for assuring isolation and preventing interference between circuit blocks in a semiconductor device are strongly demanded.

In a conventional semiconductor device, in order to assure the isolation, ground terminals and power supply terminals are isolated from each other in units of circuit blocks. Each ground terminal is connected to a semiconductor substrate in order to prevent a drawback such as latch-up. However, with respect to a circuit such as a low noise amplifier which must be prevented from interference especially from another circuit or a circuit which must be prevented from interference especially to another circuit due to generation of a large-current/high-voltage amplitude, a ground terminal of such a circuit may not be connected even to a semiconductor substrate. In this case, since the ground terminal which is not connected to the semiconductor substrate decreases in electrostatic withstand voltage, an electrostatic breakdown protection element (hereinafter referred to as a "protection element") must be connected to the ground terminal, like another ordinary input/output terminal (for example, see Patent Document 1). However, when such a protection element is connected to the ground terminal, it is often the case that the isolation cannot be assured, or electric characteristics are deteriorated.

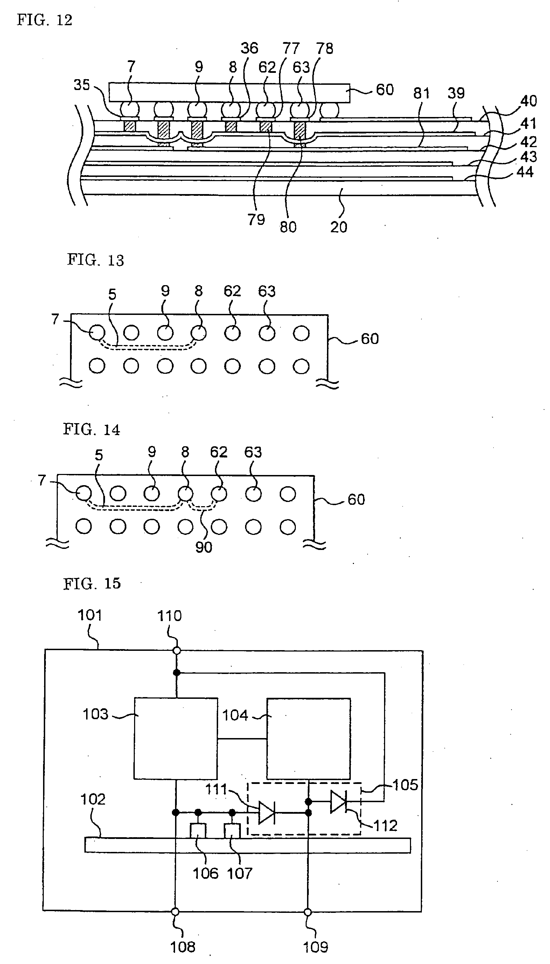

A semiconductor device having a conventional protection element will be described below. FIG. 15 is a diagram for typically showing a configuration of the semiconductor device having the conventional protection element. As shown in FIG. 15, a semiconductor device 101 includes a semiconductor substrate 102, a first internal circuit 103, a second internal circuit 104, a protection element 105, two substrate contacts 106 and 107, two ground terminals 108 and 109, and a power supply terminal 110. The first and second internal circuits 103 and 104 are circuit blocks obtained when integrated circuits formed on the semiconductor substrate 2 are isolated from each other in units of functions. The first ground terminal 108 is connected to the first internal circuit 103 and also connected to the semiconductor substrate 102 through the substrate contacts 106 and 107. On the other hand, the second ground terminal 109 is connected to the second internal circuit 104, but is not connected to the semiconductor substrate 102. The first ground contact 107 and the second ground terminal 108 assure isolation between the first internal circuit 103 and the second internal circuit 104, and are isolated from each other in units of circuit blocks to prevent interference. The protection element 105 is connected to the second ground terminal 109 which is not connected to the semiconductor substrate 102. The protection element 105 includes two diodes 111 and 112. The first diode 111 is connected between the first ground terminal 108 and the second ground terminal 109, and the second diode 112 is connected between the second ground terminal 109 and the power supply terminal 110.

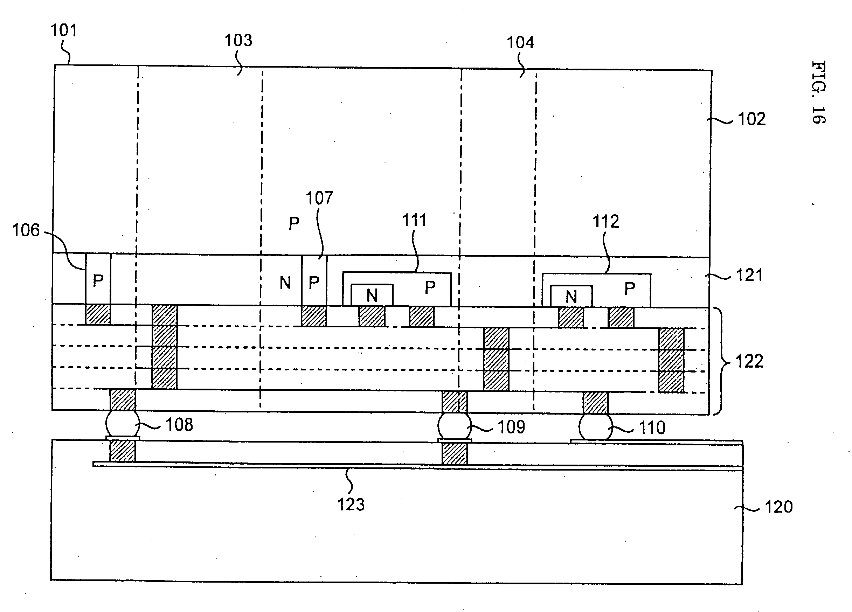

The semiconductor device 101 is a semiconductor package having a package including the semiconductor substrate 102, the first and second internal circuits 103 and 104, the protection element 105, the two substrate contacts 106 and 107 therein, and is generally used while being mounted on a packaging substrate. FIG. 16 is a diagram showing a package obtained by packaging the semiconductor device 101 in, e.g., a Wafer Level Chip Size Package (hereinafter referred to as a "WLCSP"). As shown in FIG. 16, the semiconductor device 101 is mounted on a packaging substrate 120.

The semiconductor device 101 includes, for example, the semiconductor substrate 102 such as a p-type silicon substrate. On the upper side of the semiconductor substrate 102, an n-type semiconductor layer 121 is formed, and on the upper side of then-type semiconductor layer 121, a laminate portion 122 obtained by alternatively stacking interconnection layers and insulating layers is formed. In the n-type semiconductor layer 121, the two substrate contacts 106 and 107 which are p-type semiconductors and the first and second diodes 111 and 112 consisting of a p-type semiconductor and an n-type semiconductor are formed.

In case of a WLCSP, the first and second ground terminals 108 and 109 and the power supply terminal 110 are constituted by solder balls, respectively. The constituent elements of the semiconductor device 101 are connected to form the circuit shown in FIG. 15, by using a plurality of electrodes arranged on an interconnection layer constituting the laminate portion 122 and using a plurality of via holes for connecting the electrodes to each other. The first and second ground terminals 108 and 109 are connected to a ground electrode 123 arranged in the packaging substrate 120 through via holes, respectively.

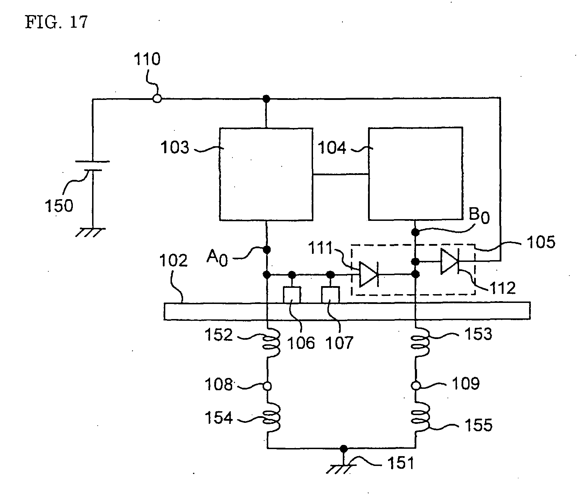

When the semiconductor device 101 is mounted on the packaging substrate 120 as shown in FIG. 16, a connection relationship between the semiconductor device 101 and the packaging substrate 120 is shown in FIG. 17. FIG. 17 is a circuit diagram showing the connection relationship between the semiconductor device 101 and the packaging substrate 120. As shown in FIG. 17, a power supply 150 is connected to the power supply terminal 110. The first and second ground terminals 108 and 109 are connected to the ground electrode 123 to be grounded on a ground plane 151. Furthermore, since there exist parasitic inductances in the interconnection formed in the interconnection layer and between the interconnections, a parasitic inductance 152 is present between a ground terminal Ao of the first internal circuit 103 and the ground terminal 108, and a parasitic inductance 153 is present between a ground terminal Bo of the second internal circuit 104 and the second ground terminal 109. Parasitic inductances 154 and 155 are also present between the first ground terminal 108 and the ground plane 151 and between the second ground terminal 109 and the ground plane 151, respectively.

Generally, when used in a packaging state, since the first and second ground terminals 108 and 109 are grounded on the ground plane, electrostatic surge is not applied from the first and second ground terminals 108 and 109. However, in a manufacturing process or a shipping/delivery process, since these ground terminals are not grounded, it must be considered that an electrostatic surge is also applied to the first and second ground terminals 108 and 109. The following describes a case in which the electrostatic surge is applied to the ground terminals 108 and 109 when the first and second ground terminals 108 and 109 are not grounded. When the first and second ground terminals 108 and 109 are not grounded, in application of an electrostatic surge to the first ground terminal 108, the electrostatic surge escapes to the semiconductor substrate 102 and are bypassed, and therefore, the electrostatic surge is not applied to the first internal circuit 103. On the other hand, in the case where the electrostatic surge is applied to the second ground terminal 109, there is no router for bypassing the electrostatic surge because the second ground terminal 109 is not connected to the semiconductor substrate 102, and the electrostatic surge may be applied to the second internal circuit 104. In this case, the protection element 105 protects the second internal circuit 104 from the electrostatic surge.

An operation of the protection element 105 is as follows. When a negative electrostatic surge having a voltage lower than the voltage of the first ground terminal 108 is applied to the second ground terminal 109, the diode 111 is turned on to bypass a surge current from the second ground terminal 109 to the first ground terminal 108, so that the second internal circuit 104 is protected. When a positive electrostatic surge having a voltage higher than that of the power supply terminal 110 is applied to the second ground terminal 109, the diode 112 is turned on to bypass a surge current from the second ground terminal 109 to the power supply terminal 110, so that the second internal circuit 104 is protected.

Patent Document 1: Japanese Patent Unexamined Laid-open Publication No. 2000-307061

DISCLOSURE OF THE INVENTION

PROBLEM TO BE SOLVED BY THE INVENTION

However, since the first and second diodes 111 and 112 in the protection element 105 have parasitic capacitance components, isolation between the first internal circuit 103 and the second internal circuit 104 may not be sufficiently assured. For example, when a noise is generated in the first internal circuit 103, the noise transmits to the semiconductor substrate 102 and may transmit to the second internal circuit 104 through the parasitic capacitance component of the diode 111. The noise of the first internal circuit 103 transmits from the power supply terminal 110 to the second ground terminal 109 through the parasitic capacitance component of the second diode 112 and may transmit to the second internal circuit 104. In other words, there has been a problem that the isolation can not be assured due to the parasitic capacitance components of the first and second diodes 111 and 112, even with such a countermeasure that the first and second ground terminals 108 and 109 are isolated from each other to disconnect the second ground terminal 109 from the semiconductor substrate 102 in order to assure the isolation between the first internal circuit 103 and the second internal circuit 104. Another problem has been noted that the substrate contact 107 is often connected near the first diode 111, as shown in FIG. 15, and isolation between the second internal circuit 4 and a semiconductor substrate 3 is deteriorated disadvantageously. Furthermore, there has also been a problem, which is known as a trade-off between the parasitic capacitance component and the electrostatic withstand voltage, that when the first and second diodes 111 and 112 are reduced in size to reduce the parasitic capacitance components in order to assure isolation between the first internal circuit 3 and the second internal circuit 4, an electrostatic withstand voltage decreases.

Moreover, not only the parasitic capacitance components of the first and second diodes 111 and 112 in the circuit in FIG. 17, but also the first diode in an ON state could deteriorate the isolation. For example, when the second internal circuit 104 is a circuit in which large DC electricity flows, a potential at a point Bo may decreases from a potential at a point Ao by more than a voltage of turning on the first diode 111 due to the influence of the parasitic inductances 153 and 155. Consequently, such a problem arises that turning the first diode 111 ON makes it impossible to isolate the second internal circuit 4 from the first internal circuit 1 or the semiconductor substrate 3.

When there are many circuits provided on the semiconductor substrate 102 other than the first and second internal circuits 101 and 102, and when these circuits are logic circuits or circuits which outputs large signals, various types of noise are frequently present in the semiconductor substrate 102. In order to assure isolation from the semiconductor substrate 102 including noises from the various circuits is very important for the second internal circuit 102 to prevent interference of noises or the like.

The present invention has been made to solve the above problems, and it is an object of the present invention to provide a semiconductor device having an electrostatic breakdown protection element, which makes it possible for a circuit disposed on a semiconductor substrate to obtain a high electrostatic withstand voltage while assuring sufficient isolation from a semiconductor substrate and other circuits disposed thereon.

MEANS FOR SOLVING PROBLEM

A semiconductor device having an electrostatic breakdown protection element according to the present invention includes a semiconductor substrate on which an integrated circuit is formed, a first ground terminal and a second ground terminal each electrically connecting the integrated circuit to an external ground electrode, and an electrostatic breakdown protection element electrically connecting the first ground terminal and the second ground terminal. The first ground terminal is electrically connected to the semiconductor substrate, and the second ground terminal is not electrically connected to the semiconductor substrate. This semiconductor device is referred to as the first semiconductor device, hereinafter.

Preferably, the integrated circuit comprises a first circuit which is connected to the first ground terminal and a second circuit which is connected to the second ground terminal. This semiconductor device is referred to as the second semiconductor device, hereinafter.

Preferably, the second circuit is a low noise amplifier circuit and the first circuit is a control circuit for controlling a current flowing in the low noise amplifier circuit. This semiconductor device is referred to as the third semiconductor device, hereinafter.

Preferably, any one of the first to third semiconductor device further comprises a laminate portion constructed by alternatively stacking at least one interconnection layer and at least one insulating layer formed above the semiconductor substrate. The electrostatic breakdown protection element is provided in the interconnection layer farthest apart from the semiconductor substrate. This semiconductor device is referred to as the fourth semiconductor device, hereinafter.

Preferably, any one of the first to third device further comprises a laminate portion constructed by alternatively stacking at least one interconnection layer and at least one insulating layer formed above the semiconductor substrate, and a package including the semiconductor substrate and the laminate portion inside thereof. The package is a ball grid array package or a wafer level chip size package, and at least one of the interconnection layers is a re-interconnection layer. The electrostatic breakdown protection element is provided in the re-interconnection layer. This semiconductor device is referred to as the fifth semiconductor device, hereinafter.

Preferably, in any one of the first to fifth semiconductor device, the electrostatic breakdown protection element is an aluminum interconnection. This semiconductor device is referred to as the sixth semiconductor device, hereinafter.

Preferably, in any one of the first to fifth semiconductor device, the electrostatic breakdown protection element is a copper interconnection. This semiconductor device is referred to as the seventh semiconductor device, hereinafter.

Preferably, in any one of the first to seventh semiconductor device, the length between the first ground terminal and the second ground terminal of the electrostatic breakdown protection element is equal to or larger than 2 mm.

EFFECT OF THE INVENTION

The semiconductor device having an electrostatic breakdown protection element according to the present invention includes a semiconductor substrate on which an integrated circuit is formed, a first ground terminal and a second ground terminal each electrically connecting the integrated circuit and an external ground electrode, and an electrostatic breakdown protection element electrically connecting the first ground terminal and the second ground terminal, where the first ground terminal is electrically connected to the semiconductor substrate while the second ground terminal is not electrically connected to the semiconductor substrate, and thus, it is possible to obtain a circuit having a high electrostatic withstand voltage while sufficiently assuring isolation from other circuits on the same semiconductor substrate or from the semiconductor substrate.

BRIEF DESCRIPTION OF THE DRAWINGS

   FIG. 1 is a diagram typically showing a configuration of a semiconductor device 1 having an electrostatic breakdown protection element according to the present invention;

FIG. 2 is a diagram showing a packaging of the semiconductor device 1 on a packaging substrate 20 and showing the configuration of the semiconductor device 1 in more details;

FIG. 3 is a diagram showing a packaging of the semiconductor device 1 on the packaging substrate 20 and showing the configuration of the packaging substrate 20 in more details;

FIG. 4 is a plan view obtained when the semiconductor device 1 is viewed from a surface on which solder balls are formed;

FIG. 5 is a circuit diagram showing a connection relationship between the semiconductor device 1 and the packaging substrate 20;

FIG. 6 is a circuit diagram for explaining a manner of transmission of noise generated by a first internal circuit 3 to a second internal circuit 4;

FIG. 7 is a graph showing an example of a relationship between a noise frequency and an output impedance of the first internal circuit 3 when viewed from a point A;

FIG. 8 is a graph showing an example of a relationship between a noise frequency and an output impedance of the second internal circuit 4 when viewed from a point B;

FIG. 9 is a graph showing a relationship between an inductance component of a protection element 5 and isolation;

FIG. 10 is a diagram typically showing the configuration of a semiconductor device 60 having two ground terminals which are connected to a semiconductor substrate and one ground terminal which is not connected to the semiconductor substrate;

FIG. 11 is a diagram showing a packaging of a semiconductor device 60 on the packaging substrate 20 and showing the configuration of the semiconductor device 60 in more details;

FIG. 12 is a diagram showing a packaging of a semiconductor device 60 on the packaging substrate 20 and showing the configuration of the packaging substrate 20 in more details;

FIG. 13 is a plan view obtained when the semiconductor device 60 is viewed from a surface on which solder balls are formed;

FIG. 14 is a plan view obtained when the semiconductor device 60 is viewed from a surface on which solder balls are formed;

FIG. 15 is a diagram typically showing the configuration of a semiconductor device 101 having a conventional protection element;

FIG. 16 is a diagram showing a packaging of a semiconductor device 101 on a packaging substrate 120 and showing the configuration of the semiconductor device 101 in more details; and

FIG. 17 is a circuit diagram showing a connection relationship between the semiconductor device 101 and the packaging substrate 120.

EXPLANATION OF SYMBOLS

1: Semiconductor device, 2: Semiconductor substrate, 3: First internal circuit, 4: Second internal circuit, 5: Electrostatic breakdown protection element, 6: Substrate contact, 7: First ground terminal, 8: Second ground terminal, 9: Power supply terminal

BEST MODE FOR CARRYING OUT THE INVENTION

Embodiments of the present invention will be described below with reference to the accompanying drawings.

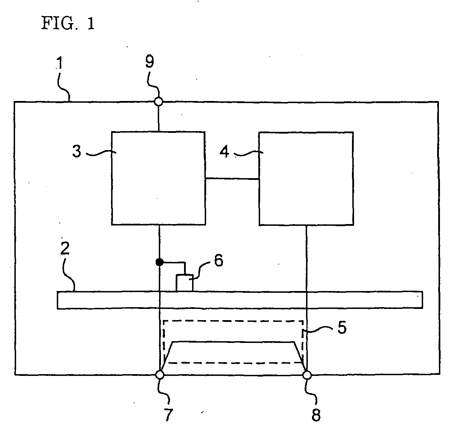

FIG. 1 is a diagram typically showing a configuration of a semiconductor device having an electrostatic breakdown protection element according to an embodiment of the present invention. As shown in FIG. 1, a semiconductor device 1 includes a semiconductor substrate 2, two internal circuits 3 and 4, an electrostatic breakdown protection element 5, a substrate contact 6, two ground terminals 7 and 8, and a power supply terminal 9. For example, the semiconductor substrate 2 is a silicon (Si) substrate. Each of the internal circuits 3 and 4 is a circuit block obtained by isolating an integrated circuit disposed on the semiconductor substrate 2 in units of functions. For example, the second internal circuit 4 is a low noise amplifier circuit, and the first internal circuit 3 is a control circuit which controls a current flowing in the low noise amplifier circuit. The first internal circuit 3 is connected to the power supply terminal 9 and the first ground terminal 7, and the second internal circuit 4 is connected to the second ground terminal 8. The first ground terminal 7 is connected to the semiconductor substrate 2 through the substrate contact 6, and the second ground terminal 8 is not connected to the semiconductor substrate 2. The first ground terminal 7 and the second ground terminal 8 assure isolation between the first internal circuit 3 and the second internal circuit 4, and are isolated in units of circuit blocks to prevent interference with each other, and the second ground terminal 8 connected to the second internal circuit 4 is not connected to the semiconductor substrate 2. The protection element 5 connects the first ground terminal 7 and the second ground terminal 8.

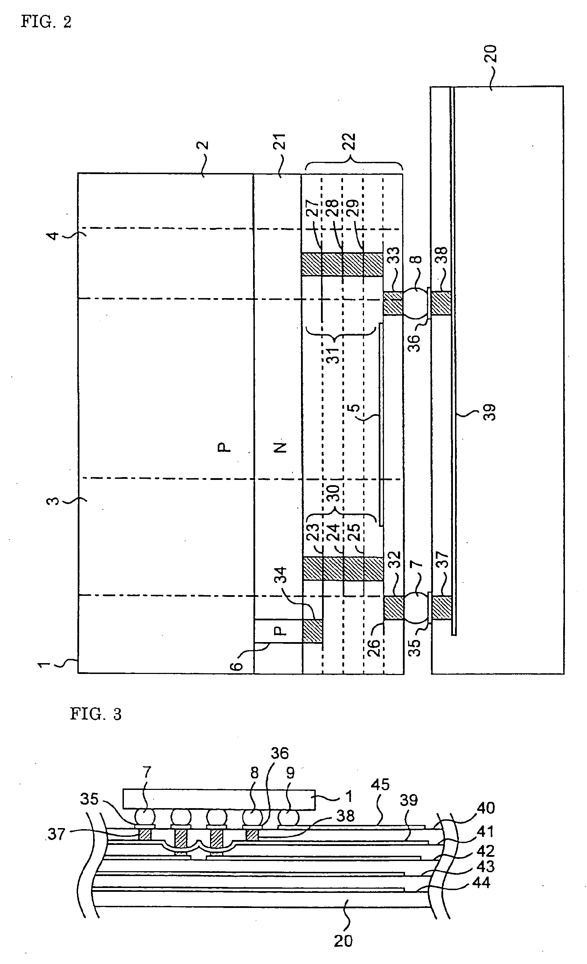

The semiconductor device 1 is a semiconductor package having a package including the semiconductor substrate 2, the first internal circuit 3, the second internal circuit 4, the protection element 5, and the substrate contact 6 therein. The semiconductor package is generally mounted on a packaging substrate to be used. In recent years, the semiconductor package is required to be reduced in size so as to be used in a notebook personal computer, a mobile telephone, and the like, and a main stream thereof is, for example, a semiconductor package having a chip size package (CSP) having a chip size equal to or slightly larger than the chip size of a Ball Grid Array (to be referred to as a BGA hereinafter) or a WLCSP. FIG. 2 is a diagram showing a packaging example mounted on a packaging substrate when the semiconductor device 1 is packaged in a WLCSP. As shown in FIG. 2, the semiconductor device 1 is mounted on the packaging substrate 20.

The semiconductor device 1 includes, for example, the semiconductor substrate 2 such as a p-type silicon substrate. An n-type semiconductor layer 21 is formed on the upper side of the semiconductor substrate 2, and a laminate portion 22 obtained by alternatively stacking interconnection layers and insulating layers is formed on the upper side of the n-type semiconductor layer 21. The substrate contact 6 consisting of a p-type semiconductor is formed in the n-type semiconductor layer 21.

In the plurality of interconnection layers of the laminate portion 22, aluminum (Al) interconnections 23 to 25 and 27 to 29 and a copper (Cu) interconnection 26 constituting the protection element 5 are formed. The Al interconnections 23 to 25 and the Al interconnections 27 to 29 are sequentially stacked from the semiconductor substrate 2 side, and the Al interconnection 23 and the Al interconnection 27, the Al interconnection 24 and the Al interconnection 28, and the Al interconnection 25 and the Al interconnection 29 are formed in the same interconnection layer, respectively. The Al interconnections 23 to 25 are connected to the first internal circuit 3, and the Al interconnections 27 to 29 are connected to the second internal circuit 4. The Cu interconnection 26 is connected to both the first internal circuit 3 and the second internal circuit 4. The interconnections 23 to 26 are electrically connected to each other through a through hole 30, and the interconnections 26 to 29 are electrically connected to each other through a through hole 31. As shown in FIG. 2, the semiconductor device 1 is mounted on the packaging substrate 20 such that the uppermost layer of the laminate portion 22 opposes the mounting surface of the packaging substrate 20.

In the WLCSP, the first and second ground terminals 7 and 8 and the power supply terminal 9 (not shown) are constituted of solder balls, respectively. The first ground terminal 7 and the second ground terminal 8 are connected to the Cu interconnection 26 through corresponding via holes 32 and 33, respectively. The substrate contact 6 serving as a p-type semiconductor is connected to the p-type semiconductor substrate 2 and also connected to the interconnection 23 through a via hole 34. In FIG. 2, for descriptive convenience, the Cu interconnection 26 is partially changed in shape, and the part changed in shape is shown as the electrostatic breakdown protection element 5. However, the Cu interconnection 26 connected between the first ground terminal 7 and the second ground terminal 8 functions as the electrostatic breakdown protection element 5 as a whole.

As shown in FIG. 2, the first ground terminal 7 is connected to an electrode 35 formed on the upper surface of the packaging substrate 20, and the second ground terminal 8 is connected to an electrode 36 formed on the upper surface of the packaging substrate 20. The electrodes 35 and 36 are connected to an interconnection 39 formed inside the packaging substrate 20 through corresponding via holes 37 and 38, respectively. The interconnection 39 functions as a ground electrode.

FIG. 3, like FIG. 2, is a diagram showing a packaging example mounted on the packaging substrate 20 of the semiconductor device 1 when the semiconductor device 1 is packaged in a WLCSP and showing the configuration of the packaging substrate 20 in more details. As shown in FIG. 3, the packaging substrate 20 includes a mounting surface 40 on which the semiconductor device 1 is mounted and a second interconnection layer 41, a third interconnection layer 42, a fourth interconnection layer 43, and a fifth interconnection layer 44 which are formed inside the packaging substrate 20. On the mounting surface 40, the electrodes 35, 36, and 45 are arranged, where the first and second ground terminals 7 and 8 and the power supply terminal 9 are connected thereto, respectively. The interconnection 39 is arranged on the second interconnection layer 41. On the packaging substrate 20, a ground electrode is generally arranged on the second interconnection layer 41.

As described above, the electrodes 35 and 36 on the mounting surface 40 are connected to the interconnection 39 arranged on the second interconnection layer 41 through the corresponding via holes 37 and 38, respectively. On the upper surface of the package of the semiconductor device 1, there may be arranged not only solder balls functioning as the first and second ground terminals 7 and 8 and the power supply terminal 9 but also other solder balls functioning as connection terminals such as a ground terminal and a power supply terminal. In this case, electrodes to which these solder balls are connected may be arranged on the mounting surface 40 of the packaging substrate 20 and the third to fifth interconnection layers 42 to 44, and furthermore, via holes may be formed in the packaging substrate 20 to connect the solder balls to the interconnections in the packaging substrate 20.

The total number of interconnections of the laminate portion 22 is not limited to the number shown in FIG. 2. When the semiconductor device 1 is a WLCSP, the. Cu interconnection 26 constituting the electrostatic breakdown protection element 5 may be an interconnection for connecting electrode pads (not shown) formed on the semiconductor substrate 2 and the solder balls formed on the upper surface of the package, i.e., may be a re-interconnection. At this time, the interconnection layer in which the Cu interconnection 26 is formed is called a re-interconnection layer.

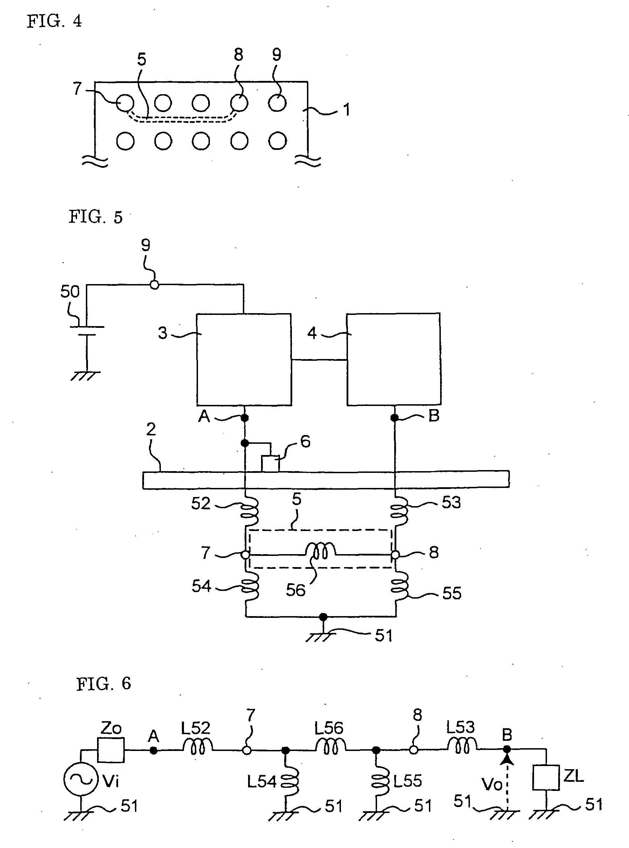

FIG. 4 is a plan view when the semiconductor device 1 is viewed from a surface on which solder balls are formed. As shown in FIG. 4, the protection element 5 is connected between the first ground terminal 7 and the second ground terminal 8.

A case in which, an electrostatic surge is applied to the first and second ground terminals 7 and 8 in the semiconductor device 1 described above when the first and second ground terminals 7 and 8 are not grounded, will be described below. When the electrostatic surge is applied to the first ground terminal 7, the electrostatic surge is bypassed to the semiconductor substrate 2 through the substrate contact 6, and therefore, the electrostatic surge is not applied to the first internal circuit 3. On the other hand, when the electrostatic surge is applied to the second ground terminal 8, the electrostatic surge is bypassed to the semiconductor substrate 2 through the first ground terminal 7, and therefore, the electrostatic surge is not applied to the second internal circuit 4. More specifically, the second internal circuit 4 is protected by the protection element 5. In the semiconductor device according to the embodiment of the present invention, the electrostatic breakdown protection element is constituted by the interconnection for connecting the first ground terminal 7 and the second ground terminal 8, and therefore, an electrostatic surge applied to the second ground terminal 8 which is not connected to the semiconductor substrate 2 can be bypassed to the first ground terminal 4, so that a high electrostatic withstand voltage can be realized. In the semiconductor device according to the embodiment, a diode is not used as an electrostatic breakdown protection element unlike in a conventional semiconductor device, and therefore, an electrostatic withstand voltage higher than that of the conventional semiconductor element can be achieved.

When the semiconductor device 1 is mounted on the packaging substrate 20 as shown in FIGS. 2 and 3, a connection relationship between the semiconductor device 1 and the packaging substrate 20 is shown in FIG. 5. FIG. 5 is a circuit diagram showing the connection relationship between the semiconductor device 1 and the packaging substrate 20. As shown in FIG. 5, a power supply 50 is connected to the power supply terminal 9. The first and second ground terminals 7 and 8 are grounded on a ground plane 52. This is because the first and second ground terminals 7 and 8 are connected to the interconnection 39 of the packaging substrate 20 functioning as a ground electrode. Furthermore, since a parasitic inductance is present in an interconnection formed in the interconnection layer and between interconnections, a parasitic inductance 52 is present between a ground terminal A of the first internal circuit 3 and the first ground terminal 7, and a parasitic inductance 53 is present between a ground terminal B of the second internal circuit 4 and the second ground terminal 8. Corresponding parasitic inductances 54 and 55 are present between the first ground terminal 7 and the ground plane 51 and between the second ground terminal 8 and the ground plane 51, respectively. Furthermore, the protection element 5 has an inductance component 56.

An influence to the second internal circuit 4 when a noise is generated by the first internal circuit 3 will be described below. FIG. 6 is a circuit diagram for explaining a manner of transmission of a noise generated by the first internal circuit 3 to the second internal circuit 4. As shown in FIG. 6, a parasitic inductance value (L value) between the ground terminal A and the second ground terminal 8 is represented by L53, a parasitic inductance value between the first ground terminal 7 and the ground plane 51 is represented by L54, and a parasitic inductance value between the second ground terminal 8 and the ground plane 51 is represented by L55. An inductance component of the protection element 5 is represented by L56. The noise generated by the first internal circuit 3 reaches the second internal circuit 4 through the parasitic inductance 52, the first ground terminal 7, the protection element 5, the second ground terminal 8, and the parasitic inductance 53. In this case, a voltage of the noise generated by the first internal circuit 3 is represented by Vi, and a voltage at a point B when the noise reaches the point B is represented by Vo. An output impedance of the first internal circuit 3 when viewed from a point A is represented by ZO, and an input impedance of the second internal circuit 4 when viewed from the point B is represented by ZL. In this case, the following equation (1) is established.

[Equation 1]

$$Vo = \frac{j\omega L54 \cdot (j\omega L56 + Z0)/(j\omega L54 + j\omega L56 + Z0)}{Z0 + j\omega L52 + j\omega L54 \times (j\omega L56 + Z0)/(j\omega L54 + j\omega L56 + Z0)}$$

$$\times \frac{Z0}{j\omega L56 + Z0} \times \frac{ZL}{j\omega L53 + ZL} \times Vi \qquad (1)$$

$$\text{where,} \quad Z0 = \frac{j\omega L55 \cdot (j\omega L53 + ZL)}{j\omega L55 + j\omega L53 + ZL}$$

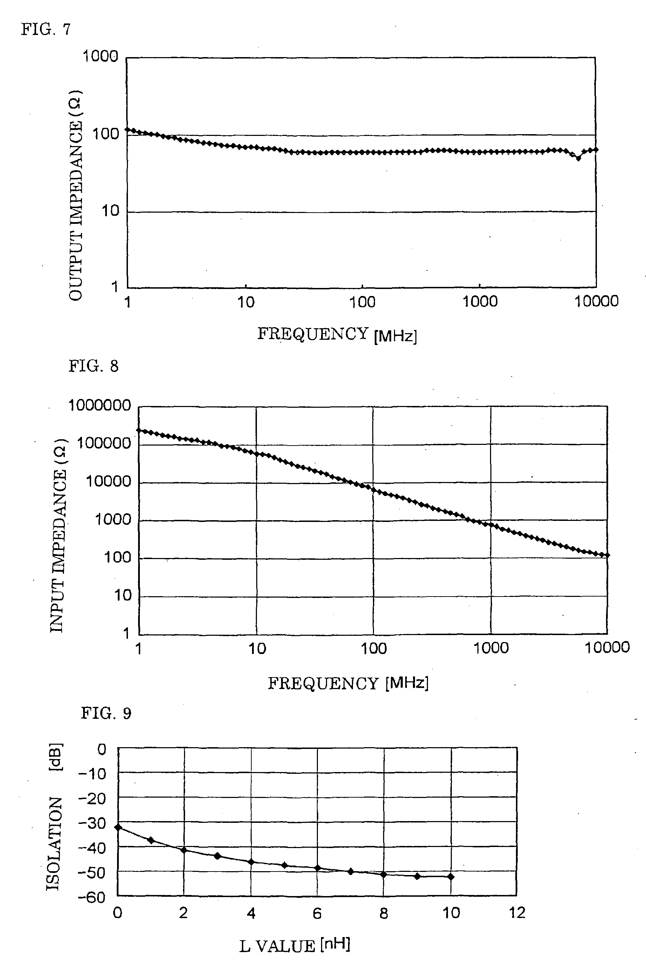

When the package of the semiconductor device 1 is a BGA package, a WLCSP, or the like, each of the values L52 to L55 is approximately 0.5 nH. When the first internal circuit 3 is, for example, a relatively large circuit including a bias circuit, an example of a relationship between a noise frequency and an output impedance of the first internal circuit 3 when viewed from the point A is shown in FIG. 7. In the graph in FIG. 7, an abscissa indicates a noise frequency, and an ordinate indicates an output impedance of the first internal circuit 3. As shown in FIG. 7, when the noise frequency is approximately 1000 MHz, i.e., 1 GHz, the magnitude of the output impedance is approximately 60 Ω.

The second internal circuit 4 is, for example, a circuit such as a low noise amplifier. At this time, an input impedance of the second internal circuit 4 when viewed from the point B is equal to an impedance of an emitter-grounded amplifier when viewed from an emitter side. FIG. 8 is a graph showing an example of a relationship between the noise frequency and the input impedance of the second internal circuit 4 when viewed from the point B. In the graph in FIG. 8, an abscissa indicates a noise frequency, and an ordinate indicates an input impedance of the second internal circuit 4. As shown in FIG. 8, when the noise frequency is approximately 1 GHz, the magnitude of the input impedance is approximately 800 Ω.

FIG. 9 is a graph showing a value Vo/Vi obtained when a value L21 which is a value of the inductance component of the protection element 5 is changed when the noise frequency is 1 GHz. In this case, it is assumed that the impedance Zo of the first internal circuit 3 is 60 Ω and that the input impedance ZL of the second internal circuit 4 when viewed from the point B is 800 Ω. In the graph in FIG. 9, an abscissa indicates a value (L value) of the inductance component of the protection element 5, and an ordinate indicates the value Vo/Vi. The value Vo/Vi indicates a degree of isolation between the first internal circuit 3 and the second internal circuit 4. The degree of isolation is practical when the degree of isolation is 20 dB or more. More preferably, the degree of isolation is 30 dB or more. Most preferably, the degree of isolation is 40 dB or more. As shown in FIG. 9, it is understood that, when the value L56 of the inductance component of the protection element 5 is approximately 2 nH, the degree of isolation of 40 dB or more can be assured. A parasitic inductance value of an interconnection is dependent on only the length of the interconnection regardless of the material and width of the interconnection, is 1 nH per 1mm, and for this reason, the interconnection functioning as the protection element 4 preferably has a length of 2 mm or more.

As is apparent from the circuit shown in FIG. 6, the smaller the values L54 and L55 are and the larger the values L52 and L53 are, the higher the degree of isolation between the first internal circuit 3 and the second internal circuit 4 is. Therefore, the protection element .5 is preferably distanced from the first and second internal circuits 3 and 4 as much as possible and preferably got close to the first and second ground terminals 7 and 8. Therefore, in the semiconductor device 1 according to the first embodiment, the interconnection 26 functioning as the protection element 5 is preferably formed in the uppermost layer in the laminate portion 22, i.e., an interconnection layer which is closest to the packaging substrate 20, or an interconnection layer which is secondly distanced from the semiconductor substrate 2 in the laminate portion 22, i.e., an interconnection layer which is secondly close to the packaging substrate 20.

When the degree of integration is increased and in the case where a logic circuit or a circuit which generates a large voltage amplitude are arranged on the same semiconductor substrate, a noise or an interference potential propagated through the semiconductor substrate is frequently posed as a problem, and therefore, it is important that a circuit such as a low noise amplifier the characteristics of which are influenced by even small noise is isolated from the semiconductor substrate as much as possible. In the semiconductor device according to the present invention, the second ground terminal 8 connected to the second internal circuit 4 is not connected to the semiconductor substrate 2, and the second ground terminal 8 is connected to the first ground terminal 7 through the protection element 5, and for this reason, the second internal circuit 4 can assure sufficient isolation from the first internal circuit 3 or the semiconductor substrate 3 while realizing a high electrostatic withstand voltage. The second internal circuit 4 can sufficiently assure isolation from the first internal circuit 3 or the semiconductor substrate 2 by the parasitic inductance component of the protection element 5. Therefore, even though the second internal circuit 4 is a low noise amplifier circuit, the second internal circuit 4 can be prevented from being erroneously operated by a noise from another circuit on the same semiconductor substrate or from the semiconductor substrate. The electrostatic breakdown protection element in the semiconductor device according to the present invention has the above advantage to a noise having a frequency of 10 MHz or more.

The semiconductor device according to the present invention uses the electrostatic breakdown protection element 5 to make it possible to reduce parasitic inductance components of the second internal circuit 4 to the ground plane 51. When the protection element 5 is absent, the values of the parasitic inductance components of the second internal circuit 4 to the ground plane 51 are expressed by L53 + L55. However, when the protection element 4 is present, the value is given by L53 + L55 · (L56 + L54) / (L55 + L56 + L54). As described above, L52 to L55 are set at 0.5 nH, L56 is set at 2 nH, and when the parasitic inductance components of the second internal circuit 4 to the ground plane 51 are provisionally calculated, the value is 1 nH when the protection element 4 is absent, and the value is 0.92 nH when the protection element 4 is present, so that the parasitic inductance component can be reduced by about 10%. A plurality of other ground terminals such as the second ground terminal 8 which is not connected to the semiconductor substrate 2 are present, and the ground terminals thereof are connected to the first ground terminal 7 through the protection element described above, and in this case, an effect of reducing the parasitic inductance components of the second internal circuit 4 to the ground plane 51 further increases. The reduction of the parasitic inductance components of the second internal circuit 4 to the ground plane 51 by the protection element 5 can advantageously improve the high-frequency characteristics of the second internal circuit 4. When the high-frequency characteristics of the second internal circuit 4 are improved, the high-frequency characteristics of the entire integrated circuits of the semiconductor device are improved.

As described above, as the protection element 5, the interconnection of the uppermost layer physically distanced from the first internal circuit 3 as much as possible is preferably used, and preferably has a length of about 2 mm, and preferably has a parasitic inductance (L) component. The material of the protection element 5 is arbitrarily determined, and may be a wire interconnection, and is preferably an Al interconnection or a Cu interconnection. In FIG. 1, the first internal circuit 3 and the second internal circuit 4 are connected to each other. However, these circuits are not necessarily connected to each other. The semiconductor substrate 2 may be an n-type semiconductor substrate or a p-type semiconductor substrate.

In the above description, the semiconductor device 1 has one ground terminal (hereinafter referred to as a "substrate connecting terminal") which is connected to the semiconductor substrate 2 and one ground terminal (hereinafter referred to as a "substrate unconnecting terminal") which is not connected to the semiconductor substrate 2. However, the semiconductor device 1 may have a plurality of substrate connecting terminals and a plurality of substrate unconnecting terminals. The number of substrate connecting terminals held by the semiconductor device 1 may be equal to or different from the number of substrate unconnecting terminals held by the semiconductor device 1.

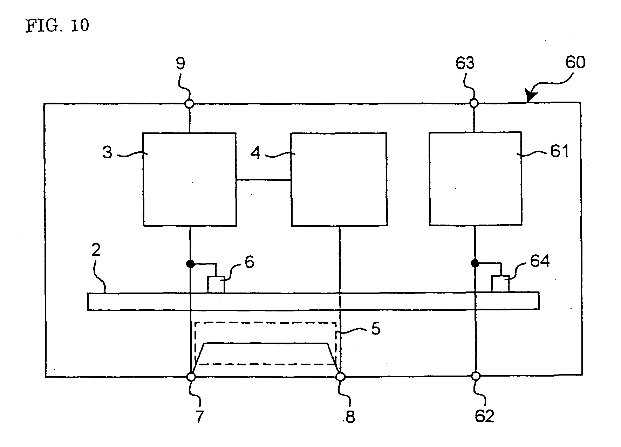

FIG. 10 is a diagram typically showing the configuration of a semiconductor device having two substrate connecting terminals and one substrate unconnecting terminal. The same reference numerals as in the semiconductor device 1 shown in FIG. 1 denote the same constituent elements in the semiconductor device 60 shown in FIG. 10, and a description thereof will be omitted. As shown in FIG. 10, the semiconductor device 60 includes a third internal circuit 61, a third ground terminal 62, a second power supply terminal 63, and a second substrate contact 64. In the following description, a power supply terminal 9 is called a first power supply terminal 9, and the substrate contact 6 is called a first substrate contact 6. As shown in FIG. 10, the third ground terminal 62 is connected to the third internal circuit 61 and connected to the semiconductor substrate 2 through the second substrate contact 64. The second power supply terminal 63 is connected to the third internal circuit 61.

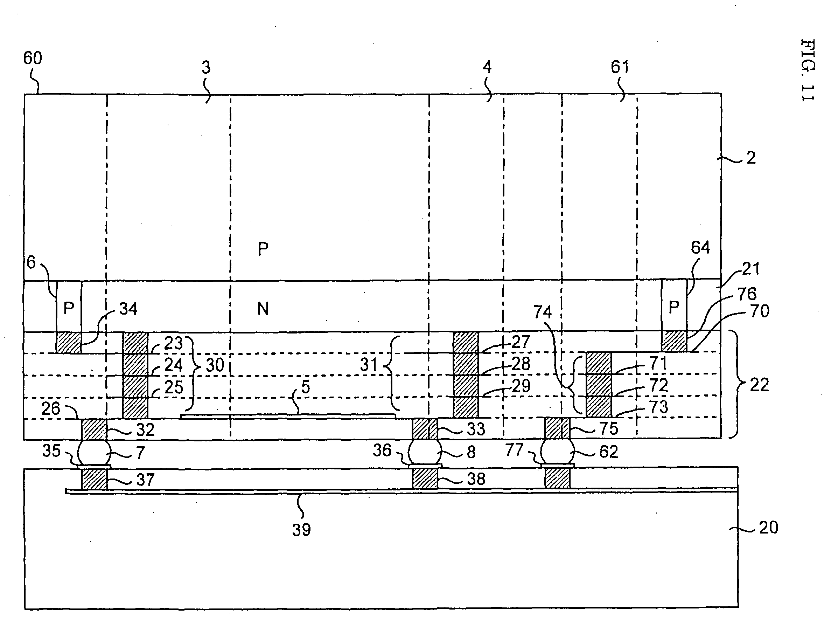

FIGS. 11 and 12 show packagings of the semiconductor device 60 on the packaging substrate 20 when the semiconductor device 60 is packaged in a WLCSP, respectively. The same reference numerals as in the configurations shown in FIGS. 11 and 12 denote the same constituent elements in the configurations shown in FIGS. 2 and 3, and description thereof will be omitted. As shown in FIG. 11, the second substrate contact 64 consisting of a p-type semiconductor is formed in the n-type semiconductor layer 21 of the semiconductor device 60, and Al interconnections 70 to 73 are arranged in a plurality of interconnection layers of a laminate portion 22. The Al interconnections 70 and 73 are connected to the third internal circuit 61. The Al interconnections 70 to 73 are electrically connected to each other through a through hole 74. In the WLCSP, the third ground terminal 62 and the second power supply terminal 63 are constituted by solder balls, respectively. The third ground terminal 62 is connected to the Al interconnection 73 through a via hole 75. The second substrate contact 64 is connected to the Al interconnection 70 through a via hole 76.

As shown in FIGS. 11 and 12, the third ground terminal 62 and the second power supply terminal 63 are connected to corresponding electrodes 77 and 78 formed on a packaging surface 40 of the packaging substrate 20, respectively. The electrode 77 is connected to a interconnection electrode 39 functioning as a ground electrode formed inside the packaging substrate 20, through a via hole 79. The electrode 78 is connected to an interconnection electrode 81 arranged in a third interconnection layer 42 inside the packaging substrate 20, through a via hole 80. As shown in FIG. 12, the first power supply terminal 9 and the second power supply terminal 63 are connected to each other by the interconnection electrode 81.

FIG. 13 is a plan view of the semiconductor device 60 when viewed from a surface on which solder balls are formed. As shown in FIG. 13, the protection element 5 is connected to the first and second ground terminals 7 and 8.

When isolation between the first internal circuit 3 and the third internal circuit 61 is not posed as a problem, another protection element may be connected between the second ground terminal 8 and the second power supply terminal 63. FIG. 14 is a plan view of the semiconductor device 60 when viewed from a surface on which solder balls are formed. As shown in FIG. 14, the protection element 5 is connected between the first ground terminal 7 and the second ground terminal 8, and another protection element 90 may be connected between the second ground terminal 8 and the third ground terminal 62.

Even in the circuit shown in FIG. 10, the second internal circuit 4 can assure sufficient isolation from the first internal circuit 3 and the semiconductor substrate 3 while realizing a high electrostatic withstand voltage.

Furthermore, even though a plurality of substrate unconnecting terminals are present, the substrate unconnecting terminals are connected to at least one substrate connecting terminal by the protection element described above, so that a circuit connected to the substrate unconnecting terminals can assure sufficient isolation from the first internal circuit 3 and the semiconductor substrate 3 while realizing a high electrostatic withstand voltage.

The present invention has been described with respect to the specific embodiments. However, many other modifications and corrections and other usage are apparent to a person skilled in the art. Therefore, the present invention is not limited to the specific disclosure described above, and can be limited by only the accompanying scope of claims.

INDUSTRIAL APPLICABILITY

An electrostatic breakdown protection element according to the present invention can be used in a semiconductor device or the like which requires a high electrostatic withstand voltage and high-frequency characteristics. In addition, a semiconductor device having the electrostatic breakdown protection element according to the present invention can be applied to a notebook personal computer, a mobile telephone, and the like.

**Claims**

1. A semiconductor device having an electrostatic breakdown protection element, comprising:

   a semiconductor substrate on which an integrated circuit is formed;
   a first ground terminal and a second ground terminal for electrically connecting the integrated circuit to an external ground electrode; and
   said electrostatic breakdown protection element electrically connecting the first ground terminal with the second ground terminal,

   wherein the first ground terminal is electrically connected to the semiconductor substrate, and the second ground terminal is not electrically connected to the semiconductor substrate.

2. The semiconductor device having the electrostatic breakdown protection element according to Claim 1, wherein the integrated circuit comprises a first circuit which is connected to the first ground terminal and a second circuit which is connected to the second ground terminal.

3. The semiconductor device having the electrostatic breakdown protection element according to Claim 2, wherein the second circuit is a low noise amplifier circuit and the first circuit is a control circuit for controlling a current flowing in the low noise amplifier circuit.

4. The semiconductor device having the electrostatic breakdown protection element according to any one of Claims 1 to 3, further comprising a laminate portion constructed by alternatively stacking at least one interconnection layer and at least one insulating layer formed above the semiconductor substrate,
   wherein the electrostatic breakdown protection element is provided in the interconnection layer farthest apart from the semiconductor substrate.

5. The semiconductor device having the electrostatic breakdown protection element according to any one of Claims 1 to 3, further comprising a laminate portion constructed by alternatively stacking at least one interconnection layer and at least one insulating layer formed above the semiconductor substrate, and

a package including the semiconductor substrate and the laminate portion inside thereof,

wherein the package is a ball grid array package or a wafer level chip size package, and at least one of the interconnection layers is a re-interconnection layer, and the electrostatic breakdown protection element is provided in the re-interconnection layer.

6. The semiconductor device having the electrostatic breakdown protection element according to any one of Claims 1 to 5, wherein the electrostatic breakdown protection element is an aluminum interconnection.

7. The semiconductor device having the electrostatic breakdown protection element according to any one of Claims 1 to 5, wherein the electrostatic breakdown protection element is a copper interconnection.

8. The semiconductor device having the electrostatic breakdown protection element according to any one of Claims 1 to 7, wherein the length between the first ground terminal and the second ground terminal of the electrostatic breakdown protection element is equal to or larger than 2 mm.

**Amended claims under Art. 19.1 PCT**

1. A semiconductor device having an electrostatic breakdown protection element, comprising:

    a semiconductor substrate on which an integrated circuit is formed;
    a first ground terminal and a second ground terminal for electrically connecting the integrated circuit to an external ground electrode; and
    said electrostatic breakdown protection element which comprises of an interconnection for electrically connecting the first ground terminal with the second ground terminal,

    wherein the first ground terminal is electrically connected to the semiconductor substrate, and the second ground terminal is not electrically connected to the semiconductor substrate.

2. The semiconductor device having the electrostatic breakdown protection element according to Claim 1, wherein the integrated circuit comprises a first circuit which is connected to the first ground terminal and a second circuit which is connected to the second ground terminal.

3. The semiconductor device having the electrostatic breakdown protection element according to Claim 2, wherein the second circuit is a low noise amplifier circuit and the first circuit is a control circuit for controlling a current flowing in the low noise amplifier circuit.

4. The semiconductor device having the electrostatic breakdown protection element according to any one of Claims 1 to 3, further comprising a laminate portion constructed by alternatively stacking at least one interconnection layer and at least one insulating layer formed above the semiconductor substrate,

wherein the electrostatic breakdown protection element is provided in the interconnection layer farthest apart from the semiconductor substrate.

5. The semiconductor device having the electrostatic breakdown protection element according to any one of Claims 1 to 3, further comprising a laminate portion constructed by alternatively stacking at least one interconnection layer and at least one insulating layer formed above the semiconductor substrate, and

a package including the semiconductor substrate and the laminate portion inside thereof,

wherein the package is a ball grid array package or a wafer level chip size package, and at least one of the interconnection layers is a re-interconnection layer, and the electrostatic breakdown protection element is provided in the re-interconnection layer.

6. The semiconductor device having the electrostatic breakdown protection element according to any one of Claims 1 to 5, wherein the electrostatic breakdown protection element is an aluminum interconnection.

7. The semiconductor device having the electrostatic breakdown protection element according to any one of Claims 1 to 5, wherein the electrostatic breakdown protection element is a copper interconnection.

8. The semiconductor device having the electrostatic breakdown protection element according to any one of Claims 1 to 7, wherein the length between the first ground terminal and the second ground terminal of the electrostatic breakdown protection element is equal to or larger than 2 mm.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

## INTERNATIONAL SEARCH REPORT

| | International application No. |
|---|---|
| | PCT/JP2004/017701 |

**A. CLASSIFICATION OF SUBJECT MATTER**
Int.Cl⁷ H01L27/04, H01L23/60

According to International Patent Classification (IPC) or to both national classification and IPC

**B. FIELDS SEARCHED**

Minimum documentation searched (classification system followed by classification symbols)
Int.Cl⁷ H01L27/04, H01L23/60

Documentation searched other than minimum documentation to the extent that such documents are included in the fields searched
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2001-345426 A (Unisia Jecs Corp.),<br>14 December, 2001 (14.12.01),<br>Par Nos. [0046] to [0052]; Fig. 3<br>(Family: none) | 1-3,8<br>4-7 |
| X<br>A | JP 01-239877 A (Sharp Corp.),<br>25 September, 1989 (25.09.89),<br>Page 3, upper left column, line 12 to page 3,<br>lower left column, line 20; Fig. 3<br>(Family: none) | 1-3,8<br>4-7 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>17 January, 2005 (17.01.05) | Date of mailing of the international search report<br>01 February, 2005 (01.02.05) |
|---|---|
| Name and mailing address of the ISA/<br>Japanese Patent Office | Authorized officer |
| Facsimile No. | Telephone No. |

Form PCT/ISA/210 (second sheet) (January 2004)

**EP 1 701 385 A1**

<table>
<tr><td colspan="3" style="text-align:center">**INTERNATIONAL SEARCH REPORT**</td><td>International application No.<br>PCT/JP2004/017701</td></tr>
</table>

C (Continuation). DOCUMENTS CONSIDERED TO BE RELEVANT

| Category* | Citation of document, with indication, where appropriate, of the relevant passages | Relevant to claim No. |
|---|---|---|
| P,A | JP 2004-193170 A (Matsushita Electric Industrial Co., Ltd.), 08 July, 2004 (08.07.04), Full text; all drawings & EP 1427015 A2 Full text; all drawings & CN 1507052 A  & KR 4049782 A & US 2004/0108577 A1 | 1-8 |
| A | JP 2003-152091 A (Matsushita Electric Industrial Co., Ltd.), 23 May, 2003 (23.05.03), Full text; all drawings (Family: none) | 1-8 |
| A | JP 06-163823 A (Toshiba Corp.), 10 June, 1994 (10.06.94), Full text; all drawings & US 5994741 A Full text; all drawings | 1-8 |
| A | JP 05-291492 A (Seiko Epson Corp.), 05 November, 1993 (05.11.93), Full text; all drawings (Family: none) | 1-8 |

Form PCT/ISA/210 (continuation of second sheet) (January 2004)

23

**EP 1 701 385 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000307061 A